(19) **Europäisches Patentamt / European Patent Office / Office européen des brevets**

(11) **EP 2 283 396 B1**

(12) # EUROPEAN PATENT SPECIFICATION

(45) Date of publication and mention
of the grant of the patent:
**13.03.2013 Bulletin 2013/11**

(51) Int Cl.:
***G03F 7/20*** (2006.01)     ***G21K 1/06*** (2006.01)
***G03F 1/00*** (2012.01)

(21) Application number: **09757397.6**

(22) Date of filing: **20.05.2009**

(86) International application number:
**PCT/EP2009/056130**

(87) International publication number:
**WO 2009/147014 (10.12.2009 Gazette 2009/50)**

(54) **MULTILAYER MIRROR AND LITHOGRAPHIC APPARATUS**

MEHRSCHICHTIGER SPIEGEL UND LITHOGRAPHIEVORRICHTUNG DAMIT

MIROIR MULTICOUCHE ET APPAREIL LITHOGRAPHIQUE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **04.06.2008 US 129087**

(43) Date of publication of application:
**16.02.2011 Bulletin 2011/07**

(73) Proprietor: **ASML Netherlands BV**
**5504 DR Veldhoven (NL)**

(72) Inventors:
• **GLUSHKOV, Denis**
**53347 Alfter (DE)**
• **BANINE, Vadim**
**NL-5704 NK Helmond (NL)**
• **MOORS, Johannes, Hubertus, Josephina**
**NL-5709 MT Helmond (NL)**

• **SJMAENOK, Leonid, Aizikovitch**
**NL-6291 GP Vaals (NL)**
• **SALASCHENKO, Nikolai Nikolaevich**
**Nizhny 603024 (RU)**

(74) Representative: **Slenders, Petrus J. W.**
**ASML Netherlands B.V.**
**Corporate Intellectual Property**
**P.O. Box 324**
**5500 AH Veldhoven (NL)**

(56) References cited:
**US-A- 5 528 654**     **US-A- 5 641 593**
**US-A1- 2004 047 446**     **US-B1- 6 449 086**

• **WINDT D L: "IMD-Software for modeling the optical properties of multilayer films" COMPUTERS IN PHYSICS AIP USA, vol. 12, no. 4, July 1998 (1998-07), pages 360-370, XP002545521 ISSN: 0894-1866**

**Description**

CROSS-REFERENCE TO RELATED APPLICATIONS

This application claims the benefit of US provisional application 61/129,087, which was filed on June 4th, 2008.

FIELD

The present invention relates to a multilayer mirror and a lithographic apparatus that includes such a multilayer mirror.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned.

Lithography is widely recognized as one of the key steps in the manufacture of ICs and other devices and/or structures. However, as the dimensions of features made using lithography become smaller, lithography is becoming a more critical factor for enabling miniature IC or other devices and/or structures to be manufactured.

A lithographic apparatus typically comprises an illumination system configured to condition a radiation beam; a support structure constructed to hold a patterning device, mostly a reticle or mask, the patterning device being capable of imparting the radiation beam with a pattern in its cross-section to form a patterned radiation beam; a substrate table constructed to hold a substrate; and a projection system configured to project the patterned radiation beam onto a target portion of the substrate.

A theoretical estimate of the limits of pattern printing can be given by the Rayleigh criterion for resolution as shown in equation (1):

$$CD = k_1 * \frac{\lambda}{NA_{PS}} \qquad (1)$$

where $\lambda$ is the wavelength of the radiation used, $NA_{PS}$ is the numerical aperture of the projection system used to print the pattern, $k_1$ is a process dependent adjustment factor, also called the Rayleigh constant, and CD is the feature size (or critical dimension) of the printed feature. It follows from equation (1) that reduction of the minimum printable size of features can be obtained in three ways: by shortening the exposure wavelength $\lambda$, by increasing the numerical aperture $NA_{PS}$, or by decreasing the value of $k_1$.

In order to shorten the exposure wavelength and, thus, reduce the minimum printable size, it has been proposed to use an extreme ultraviolet (EUV) radiation source. EUV radiation sources are configured to output a radiation wavelength of about 13.5 nm. Thus, EUV radiation sources may constitute a significant step toward achieving small features printing. Such radiation is termed extreme ultraviolet or soft x-ray, and possible sources include, for example, laser-produced plasma sources, discharge plasma sources, or synchrotron radiation from electron storage rings.

Preferably, both the illumination system and the projection system comprise a plurality of optical elements in order to focus the radiation on the desired locations on the patterning device and the substrate, respectively. Unfortunately, apart from some gasses at low density, no materials are known to be transmissive to EUV radiation. Therefore, the lithographic apparatus using EUV radiation does not employ lenses in its illumination system and in its projection system. Instead, the illumination system and the projection system preferably comprise mirrors. In addition, the patterning device is preferably a reflective device, i.e. a mirror having a reflective surface provided with an pattern formed by an absorptive material on the reflective surface, for the same reason.

To reflect EUV radiation having a wavelength of about 13.5 nm, multilayer mirrors have been proposed having alternating layers of Si and Mo. Such a multilayer mirror reflects the EUV radiation according to Bragg's Law. However, these mirrors do not appear to be suitable to reflect radiation having even shorter wavelengths.

SUMMARY

It is desirable to be able to construct mirrors with suitable reflective properties to reflect radiation having a wavelength of 6.9 nm and lower.

According to an aspect of the present invention, there is provided a mirror constructed and arranged to reflect radiation having a wavelength in the range of 2-8 nm. The multilayer mirror has alternating layers. The alternating layers include a first layer and a second layer. The first and second layers are selected from the group consisting of: U and $B_4C$ layers and Th and $B_4C$ layers. The multilayer mirror may have a reflective surface provided with a capping layer comprising Ru, Rh, Ta, Ti, Cs, Ba, C, Li, Ca or any combination thereof.

The multilayer mirror may be a patterning device, such as a reticle or a mask, constructed and arranged to provide a beam of the radiation with a pattern in its cross-section. Such a reticle or mask may be provided with a structure having an absorptive material arranged to define the pattern, the absorptive material being Cr, Ta, Ti, Si, Ru, Mo, Al, or any combination thereof.

According to an aspect of the present invention, there is provided a multilayer mirror constructed and arranged to reflect radiation having a wavelength in the range of 2-8 nm, for instance in the range of 2.9-3.3 nm, in the range of 4.1-4.7 nm or in the range of 6.2-6.9 nm. The multilayer mirror may have a reflective surface provided with a capping layer that includes Ru, Rh, Ta, Ti, Cs, Ba, C, Li, Ca or any combination thereof. The capping layer may be located directly on a reflective surface of the multilayer mirror.

According to an aspect of the present invention, there is provided a projection system configured to project a patterned radiation beam onto a target portion of a substrate. The projection system includes a multilayer mirror constructed and arranged to reflect radiation having a wavelength in the range of 2-8 nm. The multilayer mirror has alternating layers. The alternating layers include a first layer and a second layer. The first and second layers are selected from the group consisting of: U and $B_4C$ layers and Th and $B_4C$ layers.

According to an aspect of the present invention, there is provided a projection system configured to project a patterned radiation beam onto a target portion of a substrate. The projection system includes a multilayer mirror constructed and arranged to reflect radiation having a wavelength in the range of 2-8 nm. The multilayer mirror may have a reflective surface provided with a capping layer that includes Ru, Rh, Ta, Ti, Cs, Ba, C, Li, Ca or any combination thereof.

According to an aspect of the present invention, there is provided an illumination system configured to condition a radiation beam. The illumination system includes a multilayer mirror constructed and arranged to reflect radiation having a wavelength in the range of 2-8 nm. The multilayer mirror has alternating layers. The alternating layers include a first layer and a second layer. The first and second layers are selected from the group consisting of: U and $B_4C$ layers and Th and $B_4C$ layers.

According to an aspect of the present invention, there is provided an illumination system configured to condition a radiation beam. The illumination system includes a multilayer mirror constructed and arranged to reflect radiation having a wavelength in the range of 2-8 nm. The multilayer mirror may have a reflective surface provided with a capping layer that includes Ru, Rh, Ta, Ti, Cs, Ba, C, Li, Ca or any combination thereof.

According to an aspect of the present invention, there is provided a lithographic projection apparatus arranged to project a pattern from a patterning device onto a substrate. The lithographic apparatus includes a multilayer mirror constructed and arranged to reflect radiation having a wavelength in the range of 2-8 nm. The multilayer mirror has alternating layers. The alternating layers include a first layer and a second layer. The first and second layers are selected from the group consisting of: , U and $B_4C$ layers and Th and $B_4C$ layers.

According to an aspect of the present invention, there is provided a lithographic projection apparatus arranged to project a pattern from a patterning device onto a substrate. The lithographic apparatus includes a multilayer mirror constructed and arranged to reflect radiation having a wavelength in the range of 2-8 nm. The multilayer mirror may have a reflective surface provided with a capping layer that includes Ru, Rh, Ta, Ti, Cs, Ba, C, Li, Ca or any combination thereof.

According to an aspect of the present invention, there is provided a lithographic apparatus that includes an illumination system configured to condition a radiation beam, and a support structure constructed to hold a patterning device. The patterning device is capable of imparting the radiation beam with a pattern in its cross-section to form a patterned radiation beam. The apparatus also includes a substrate table constructed to hold a substrate, and a projection system configured to project the patterned radiation beam onto a target portion of the substrate. The illumination system and/or the projection system includes a multilayer mirror constructed and arranged to reflect radiation having a wavelength in the range of 2-8 nm. The multilayer mirror has alternating layers. The alternating layers include a first layer and a second layer. The first and second layers are selected from the group consisting of: U and $B_4C$ layers and Th and $B_4C$ layers.

According to an aspect of the present invention, there is provided a lithographic apparatus that includes an illumination system configured to condition a radiation beam, and a support structure constructed to hold a patterning device. The patterning device is capable of imparting the radiation beam with a pattern in its cross-section to form a patterned radiation beam. The apparatus also includes a substrate table constructed to hold a substrate, and a projection system configured to project the patterned radiation beam onto a target portion of the substrate. The illumination system and/or the projection system includes a multilayer mirror constructed and arranged to reflect radiation having a wavelength in the range of 2-8 nm. The multilayer mirror may have a reflective surface provided with a capping layer that includes Ru, Rh, Ta, Ti, Cs, Ba, C, Li, Ca or any combination thereof.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 schematically depicts a lithographic apparatus according to an embodiment of the present invention;

Figure 2 schematically depicts a side view of an EUV illumination system and projection system of the lithographic projection apparatus of Figure 1;

Figure 3 schematically depicts a multilayer mirror of the lithographic apparatus of Figure 1 according to an embodiment of the present invention;

Figure 4a depicts reflectance of a comparative example of the multilayer mirror of figure 3 as a function of wavelength.

Figures 4b and 4c depict reflectance of embodiments of the multilayer mirror of Figure 3 as a function of wavelength;

Figure 5 depicts an embodiment of the multilayer mirror of the lithographic apparatus of Figure 1;

Figure 6 depicts a comparative example of the multilayer mirror of the lithographic apparatus of Figure 1; and

Figure 7 depicts a comparative example of the multilayer mirror of the lithographic apparatus of Figure 1.

DETAILED DESCRIPTION

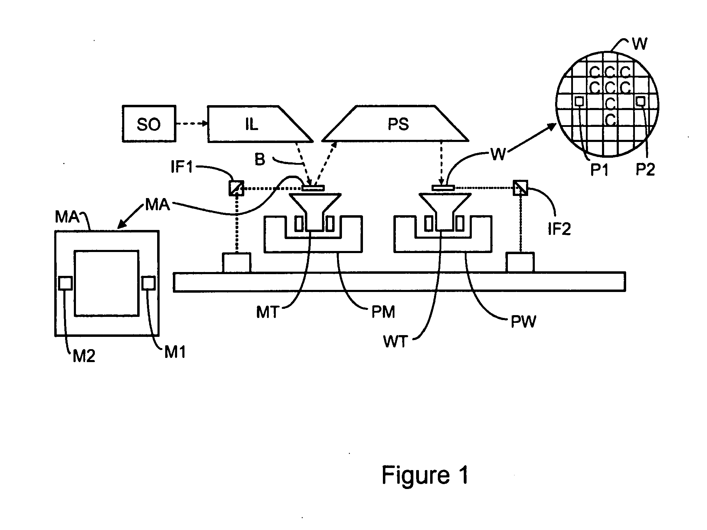

Figure 1 schematically depicts a lithographic apparatus according to an embodiment of the invention. The apparatus comprises: an illumination system (illuminator) IL configured to condition a radiation beam B (e.g. EUV radiation); a support structure (e.g. a mask table) MT constructed to support a patterning device (e.g. a mask or a reticle) MA and connected to a first positioner PM configured to accurately position the patterning device; a substrate table (e.g. a wafer table) WT constructed to hold a substrate (e.g. a resist-coated wafer) W and connected to a second positioner PW configured to accurately position the substrate; and a projection system (e.g. a reflective projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation. However, optical components which are configured to condition the radiation beam B are preferably reflective components.

The support structure holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as desired. The support structure may ensure that the patterning device is at a desired position, for example with respect to the projection system.

The term "patterning device" should be broadly interpreted as referring to any device that can be used to impart a radiation beam with a pattern in its cross-section such as to create a pattern in a target portion of the substrate. The pattern imparted to the radiation beam may correspond to a particular functional layer in a device being created in the target portion, such as an integrated circuit.

The patterning device may be transmissive, but is preferably reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" may encompass any type of projection system, including refractive, reflective, catadioptric, magnetic, electromagnetic and electrostatic optical systems, or any combination thereof, as appropriate for the exposure radiation being used, or for other factors, especially the use of a vacuum. It may be desired to use a vacuum for EUV or electron beam radiation since other gases may absorb too much radiation or electrons. A vacuum environment may therefore be provided to the whole beam path with the aid of a vacuum wall and vacuum pumps.

As here depicted, the apparatus is of a reflective type (e.g. employing a reflective mask). Alternatively, the apparatus may be of a transmissive type (e.g. employing a transmissive mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system comprising, for example, suitable directing mirrors and/or a beam expander. In other cases the source may be an integral part of the lithographic apparatus, for example when the source is a mercury lamp. The source SO and the illuminator IL, together with the beam delivery system if desired, may be referred to as a radiation system.

The illuminator IL may comprise an adjuster for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may comprise various other components, such as an integrator and a condenser. The illuminator may be used to condition the radiation beam, to have a desired uniformity and intensity distribution in its cross-section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor IF2 (e.g. an interferometric device, linear encoder or capacitive sensor), the substrate table WT can be moved accurately, e.g. so as to position different target portions C in the path of the radiation beam B. Similarly, the first positioner PM and another position sensor IF1 can be used to accurately position the patterning device (e.g. mask) MA with respect to the path of the radiation beam B. Patterning device (e.g. mask) MA and substrate W may be aligned using mask alignment marks M1, M2 and substrate alignment marks P1, P2.

The depicted apparatus could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.

3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as desired after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

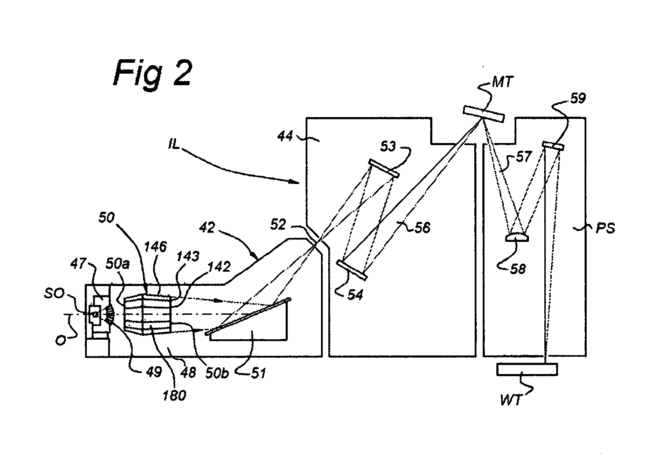

Figure 2 shows the lithographic apparatus of Figure 1 in more detail, including a radiation system 42, an illumination optics unit 44, and the projection system PS. The radiation system 42 includes the radiation source SO which may be formed by a discharge plasma. EUV radiation may be produced by a gas or vapor, for example Xe gas, Li vapor or Sn vapor in which a very hot plasma is created to emit radiation in the EUV range of the electromagnetic spectrum. The very hot plasma is created by causing an at least partially ionized plasma by, for example, an electrical discharge. Partial pressures of, for example, 10 Pa of Xe, Li, Sn vapor or any other suitable gas or vapor may be desired for efficient generation of the radiation. The radiation emitted by radiation source SO is passed from a source chamber 47 into a collector chamber 48 via a gas barrier or contaminant trap 49 which is positioned in or behind an opening in source chamber 47. The gas barrier 49 may include a channel structure.

The collector chamber 48 includes a radiation collector 50 which may be formed by a grazing incidence collector. Radiation collector 50 has an upstream radiation collector side 50a and a downstream radiation collector side 50b. Radiation passed by collector 50 can be reflected off a grating spectral filter 51 to be focused in a virtual source point 52 at an aperture in the collector chamber 48. From collector chamber 48, a beam of radiation 56 is reflected in illumination optics unit 44 via normal incidence reflectors 53, 54 onto a reticle or mask positioned on reticle or mask table MT. A patterned beam 57 is formed which is imaged in projection system PS via reflective elements 58, 59 onto wafer stage or substrate table WT. More elements than shown may generally be present in illumination optics unit 44 and projection system PS. Grating spectral filter 51 may optionally be present, depending upon the type of lithographic apparatus. Further, there may be more mirrors present than those shown in the Figures, for example there may be 1-4 more reflective elements present than 58, 59. Radiation collectors 50 are known from the prior art. The collector 50 may be a nested collector with reflectors 142, 143, and 146. A space 180 is provided between two reflectors, e.g. between reflectors 142 and 143.

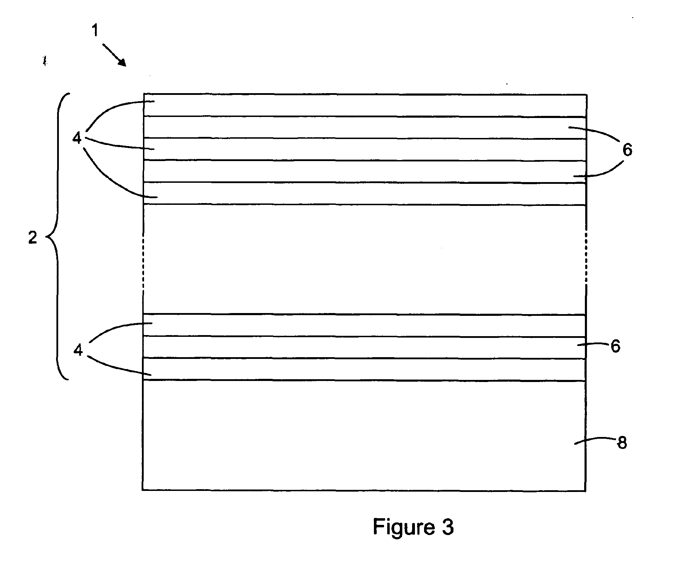

Figure 3 depicts an embodiment of the multilayer mirror 1. The multilayer mirror 1 is constructed and arranged to reflect radiation having a wavelength in the range of 2-8 nm. The multilayer mirror comprises a layered structure 2 which has alternating layers 4, 6 supported by a substrate 8.

In a comparative example, the alternating layers 4, 6 may be selected from the group consisting of: Cr and Sc layers, Cr and C layers, La and $B_4C$ layers, C and $B_4C$ layers, U and $B_4C$ layers, Th and $B_4C$ layers, C and $B_9C$ layers, La and $B_9C$ layers U and $B_9C$ layers, Th and $B_9C$ layers, La and B layers, C and B layers, U and B layers, and Th and B layers.

In a comparative example, the alternating layers 4, 6 may be selected from the group consisting of: U and $B_4C$ layers, Th and $B_4C$ layers, C and $B_9C$ layers, U and $B_9C$ layers, Th and $B_9C$ layers, C and B layers, U and B layers, and Th and B layers. A potential advantage of such alternating layers is that U layers or Th layers instead of La layers will provide a broad bandwidth, both in terms of angle as well as wavelength. The broad angle bandwidth will allow for a good amount of design freedom, making the multilayer mirror useful for optics in EUV lithography at 6.6 nm wavelength. Also, it may allow for a pupil of an optical system in which the multilayer mirror is comprised to be homogeneously filled in terms of intensity and allows for a larger numerical aperture (NA).

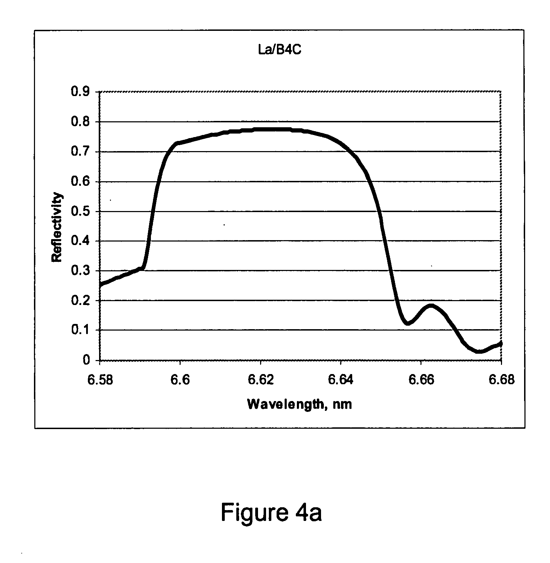

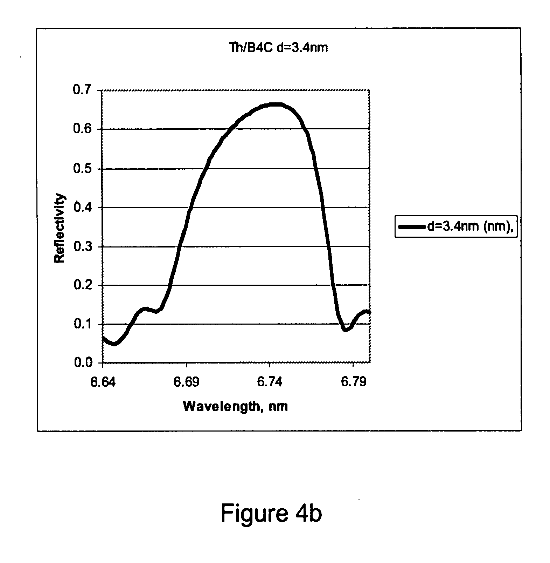

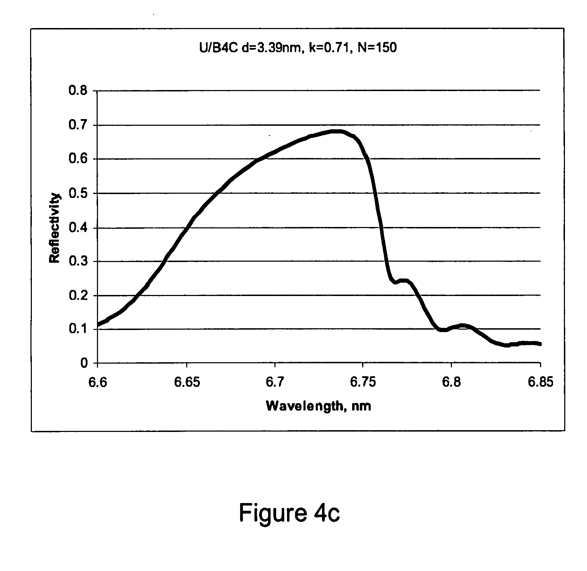

Figure 4a is a graph showing reflectance R as a function of wavelength $\lambda$ for alternating layers which are La and $B_4C$ layers. The so-called full width half maximum (FWHM) of the peak shown is 0.06 nm. Figure 4b shows reflectance as a function of wavelength $\lambda$ for alternating layers which are Th and $B_4C$ layers (Th/$B_4C$ layers). Here, the FWHM is 0.09 nm. Figure 4c shows reflectance as a function of wavelength $\lambda$ for alternating layers which are U and $B_4C$ layers (U/$B_4C$ layers). Here, the FWHM is 0.15 nm.

In a comparative example, Th/$B_9C$ layers and U/$B_9C$ layers or even Th/B layers and U/B layers may be used instead of Th/$B_4C$ layers and U/$B_4C$ layers respectively. An increased B purity may allow for better reflectivity, thereby potentially reducing power losses due to absorption of radiation.

In a comparative example, the alternating layers may be C and $B_4C$ layers, C and $B_9C$ layers, or C and B layers. C is not as active as La and, therefore, in these alternating layers not as much interlayer diffusion may occur as in La/$B_4C$ layers.

The sum of a thickness of the first layer 4 and a thickness of the second layer 6 may be within the range of 3 - 3.5 nm. The alternating layers may have a period thickness which is between about 1.7 and about 2.5 times the thickness of the first layer or the second layer.

The aforementioned examples of the multilayer mirrors 1 are mainly suitable to reflect radiation having a wavelength within a range of 3-3.5 nm. In an example, the alternating layers are Cr and Sc layers, or Cr and C layers. Cr/Sc layers have been found to be suitable to reflect radiation with a wavelength within a range of 2.9-3.3 nm. Cr/C layers have been found to be suitable to reflect radiation with a wavelength within a range of 4.1 to 4.7 nm.

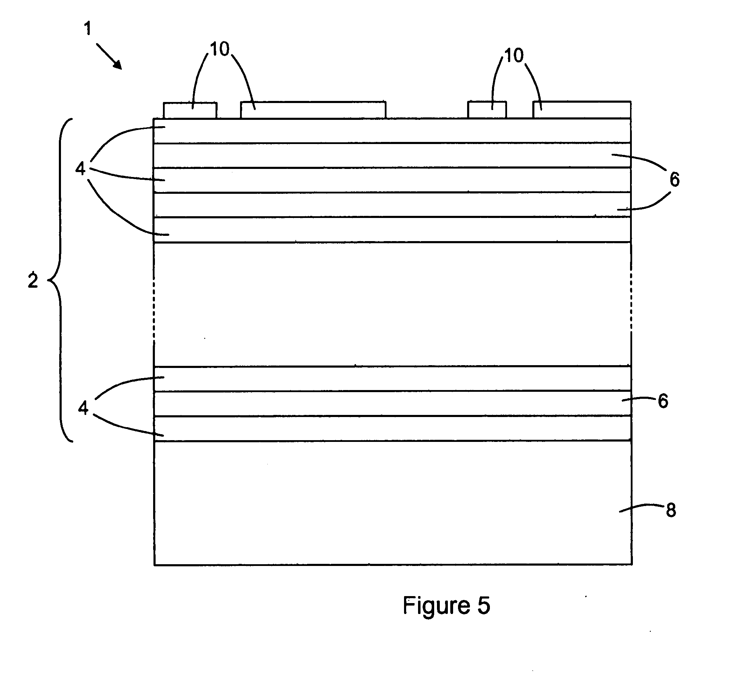

An embodiment of the multilayer mirror 1 is shown in Figure 5. This embodiment is a reflective reticle. In addition to the features of the multilayer mirror of Figure 3, the embodiment of Figure 5 may be provided with a structure having an absorptive material which is arranged to define the pattern on its surface. Suitable materials to be employed as the absorptive material may be Cr, Ti, Si, Ru, Mo, Ta, Al, or any combination thereof.

The multilayer structure 2 of the multilayer mirror 1 may be supported by a substrate 8 in order to reduce mechanical vulnerability. Also, it is to be noted that the dotted lines in Figures 3 and 5 indicate an unspecified number of repeating alternating layers 4, 6. Typically, the multilayer structure 2 of the mirror 1 is formed by a number of 30 to 200 periods of alternating layers, i.e. a total number of layers between 60 and 400. Moreover, it should be noted that the Figures are schematic Figures serving merely as illustrations and that they are not scale drawings.

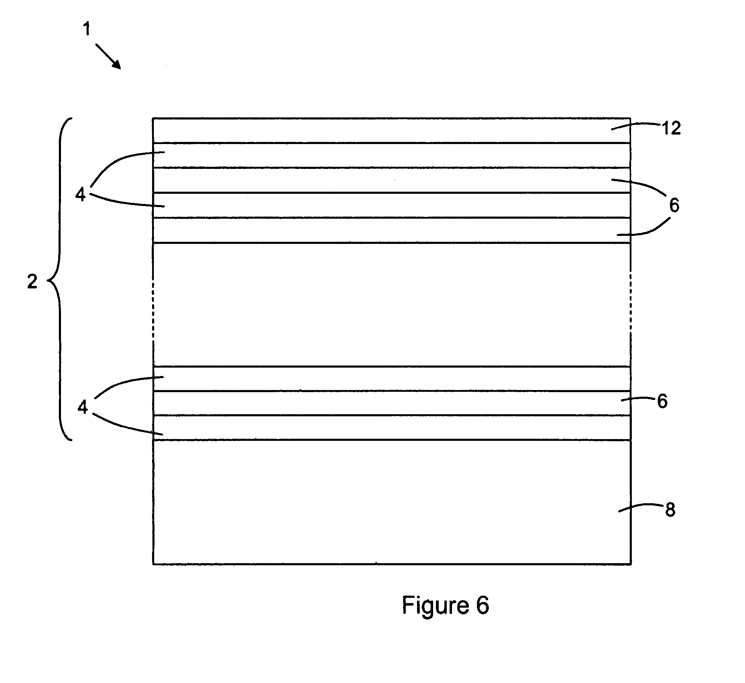

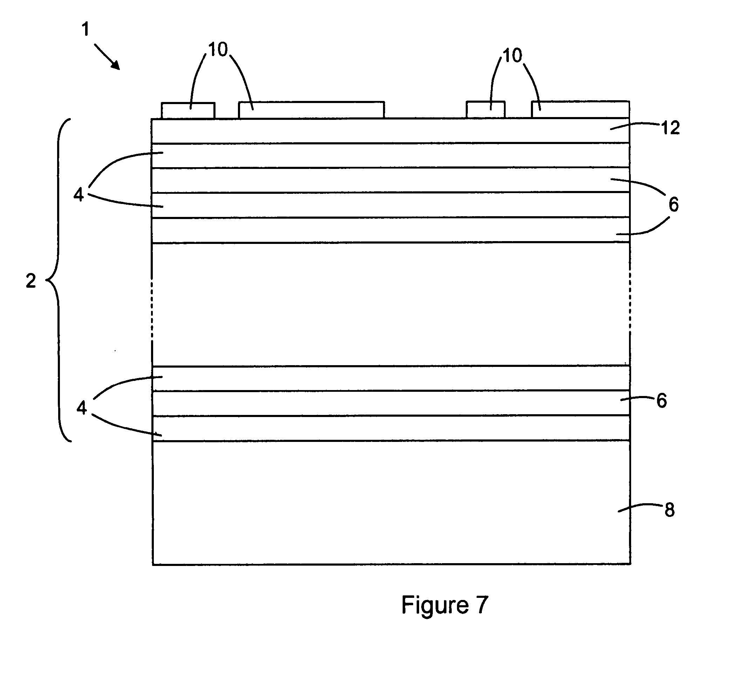

Further comparative examples of the multilayer mirror 1 are depicted in Figures 6 and 7. The example of Figure 6 is quite similar to the embodiment of Figure 3. However, in the example of Figure 6, the layered structure 2 is provided with a capping layer 12. The capping layer 12 may comprise Ru, Ta, Ti, Rh, Cs, Ba, C, Li, Ca or any combination thereof. Such a capping layer may be suitably arranged to protect the layered structure of the multilayer mirror 1 against chemical attack. A suitable thickness for the capping layer may be anywhere within the range of 0.5 to 10 nm.

Another comparative example is depicted in Figure 7. The example of Figure 7 is similar to the embodiment of Figure 4. However, in the example of Figure 7, the layered structure 2 is provided with a capping layer 12. Same as mentioned while referring to Figure 6, the capping layer 12 may comprise Ru, and/or Rh and may be suitably arranged to protect the layered structure of the multilayer mirror 1 against chemical attack.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc.

Although specific reference may have been made above to the use of embodiments of the invention in the context of optical lithography, it will be appreciated that the invention may be used in other applications, for example imprint lithography, and where the context allows, is not limited to optical lithography.

While specific embodiments of the invention have been described above, it will be appreciated that the invention may be practiced otherwise than as described. For example, the invention may take the form of a computer program containing one or more sequences of machine-readable instructions or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A multilayer mirror constructed and arranged to reflect radiation having a wavelength in the range of 2-8 nm, the multilayer mirror having alternating layers, the alternating layers comprising a first layer and a second layer, **characterized in that** the first and second layers being selected from the group consisting of: U and $B_4C$ layers and Th and $B_4C$ layers.

2. The multilayer mirror according to claim 1, wherein the sum of a thickness of the first layer and a thickness of the second layer is within the range of 3 - 3.5 nm.

3. The multilayer mirror according to claim 1 or 2, wherein the alternating layers have a period thickness which is between about 1.7 and about 2.5 times the thickness of the first layer or the second layer.

4. The multilayer mirror according to any one of claims 1, 2 or 3, wherein the multilayer mirror is constructed and arranged to reflect radiation having a wavelength in the range of 6.2-6.9 nm.

5. The multilayer mirror according to any one of the preceding claims, wherein the multilayer mirror is a patterning device constructed and arranged to provide a beam of the radiation with a pattern in its cross-section.

6. A projection system configured to project a patterned radiation beam onto a target portion of a substrate, the projection system comprising a multilayer mirror according to any one of the preceding claims.

7. An illumination system configured to condition a radiation beam, the illumination system comprising a multilayer mirror according to any one of claims 1-5.

8. A lithographic projection apparatus arranged to project a pattern from a patterning device onto a substrate, wherein the lithographic apparatus comprises a multilayer mirror according to any one of claims 1-5.

9. The lithographic apparatus according to claim 8, further comprising:

   an illumination system configured to condition a radiation beam;
   a support structure constructed to hold a patterning device, the patterning device being capable of imparting the radiation beam with a pattern in its cross-section to form a patterned radiation beam;
   a substrate table constructed to hold a substrate; and
   a projection system configured to project the patterned radiation beam onto a target portion of the substrate.

10. A lithographic apparatus comprising:

   an illumination system configured to condition a radiation beam;
   a support structure constructed to hold a patterning device, the patterning device being capable of imparting the radiation beam with a pattern in its cross-section to form a patterned radiation beam;
   a substrate table constructed to hold a substrate; and
   a projection system configured to project the patterned radiation beam onto a target portion of the substrate, wherein the projection system is a system according to claim 6 and/or the illumination system is a system according to claim 7.

**Patentansprüche**

1. Ein Mehrschichtspiegel, der konstruiert und eingerichtet ist, um Strahlung mit einer Wellenlänge in dem Bereich von 2-8 nm zu reflektieren, wobei der Mehrschichtspiegel alternierende Schichten aufweist, wobei die alternierenden Schichten eine erste Schicht und eine zweite Schicht beinhalten, **dadurch gekennzeichnet, dass** die erste und zweite Schicht aus der Gruppe ausgewählt sind, die aus Folgendem besteht: U- und $B_4C$-Schichten und Th- und $B_4C$-Schichten.

2. Mehrschichtspiegel gemäß Anspruch 1, wobei die Summe einer Dicke der ersten Schicht und einer Dicke der zweiten Schicht innerhalb des Bereichs von 3-3,5 nm liegt.

3. Mehrschichtspiegel gemäß Anspruch 1 oder 2, wobei die alternierenden Schichten eine Periodendicke aufweisen, die zwischen etwa 1,7 und etwa 2,5 mal die Dicke der ersten Schicht oder der zweiten Schicht beträgt.

4. Mehrschichtspiegel gemäß einem der Ansprüche 1, 2 oder 3, wobei der Mehrschichtspiegel konstruiert und eingerichtet ist, um Strahlung mit einer Wellenlänge in dem Bereich von 6,2-6,9 nm zu reflektieren.

5. Mehrschichtspiegel gemäß einem der vorhergehenden Ansprüche, wobei der Mehrschichtspiegel eine Musteraufbringungsvorrichtung ist, die konstruiert und eingerichtet ist, um einen Strahl der Strahlung in seinem Querschnitt mit einem Muster zu versehen.

6. Ein Projektionssystem, das konfiguriert ist, um einen gemusterten Strahlungsstrahl auf einen Zielabschnitt eines Substrats zu projizieren, wobei das Projektionssystem einen Mehrschichtspiegel gemäß einem der vorhergehenden Ansprüche beinhaltet.

7. Ein Beleuchtungssystem, das konfiguriert ist, um einen Strahlungsstrahl zu konditionieren, wobei das Beleuchtungssystem einen Mehrschichtspiegel gemäß einem der Ansprüche 1-5 beinhaltet.

8. Ein lithographisches Projektionsgerät, das eingerichtet ist, um ein Muster von einer Musteraufbringungsvorrichtung auf ein Substrat zu projizieren, wobei das lithographische Gerät einen Mehrschichtspiegel gemäß einem der Ansprüche 1-5 beinhaltet.

9. Lithographisches Gerät gemäß Anspruch 8, das ferner Folgendes beinhaltet:

   ein Beleuchtungssystem, das konfiguriert ist, um einen Strahlungsstrahl zu konditionieren;
   eine Stützstruktur, die konstruiert ist, um eine Musteraufbringungsvorrichtung zu halten,
   wobei die Musteraufbringungsvorrichtung in der Lage ist, den Strahlungsstrahl in seinem Querschnitt mit einem Muster zu versehen, um einen gemusterten Strahlungsstrahl zu bilden;
   einen Substrattisch, der konstruiert ist, um ein Substrat zu halten; und
   ein Projektionssystem, das konfiguriert ist, um den gemusterten Strahlungsstrahl auf einen Zielabschnitt des Substrats zu projizieren.

10. Ein lithographisches Gerät, das Folgendes beinhaltet:

    ein Beleuchtungssystem, das konfiguriert ist, um einen Strahlungsstrahl zu konditionieren;
    eine Stützstruktur, die konstruiert ist, um eine Musteraufbringungsvorrichtung zu halten,
    wobei die Musteraufbringungsvorrichtung in der Lage ist, den Strahlungsstrahl in seinem Querschnitt mit einem Muster zu versehen, um einen gemusterten Strahlungsstrahl zu bilden;
    einen Substrattisch, der konstruiert ist, um ein Substrat zu halten; und
    ein Projektionssystem, das konfiguriert ist, um den gemusterten Strahlungsstrahl auf einen Zielabschnitt des Substrats zu projizieren,
    wobei das Projektionssystem ein System gemäß Anspruch 6 ist und/oder das Beleuchtungssystem ein System gemäß Anspruch 7 ist.

**Revendications**

1. Un miroir multicouche construit et arrangé pour réfléchir du rayonnement ayant une longueur d'onde comprise dans la gamme allant de 2 à 8 nm, le miroir multicouche ayant des couches alternées, les couches alternées comprenant une première couche et une deuxième couche, **caractérisé en ce que** les première et deuxième couches sont sélectionnées dans le groupe consistant en : couches U et $B_4C$ et couches Th et $B_4C$.

2. Le miroir multicouche selon la revendication 1, dans lequel la somme d'une épaisseur de la première couche et d'une épaisseur de la deuxième couche est comprise au sein de la gamme allant de 3 à 3,5 nm.

3. Le miroir multicouche selon la revendication 1 ou la revendication 2, dans lequel les couches alternées ont une épaisseur de période qui fait entre environ 1,7 et environ 2,5 fois l'épaisseur de la première couche ou de la deuxième couche.

4. Le miroir multicouche selon l'une quelconque des revendications 1, 2 ou 3, le miroir multicouche étant construit et arrangé pour réfléchir du rayonnement ayant une longueur d'onde comprise dans la gamme allant de 6,2 à 6,9 nm.

5. Le miroir multicouche selon l'une quelconque des revendications précédentes, le miroir multicouche étant un dispositif servant à conformer selon un motif construit et arrangé pour fournir à un faisceau du rayonnement un motif dans sa coupe transversale.

6. Un système de projection configuré pour projeter un faisceau de rayonnement à motif sur une portion cible d'un substrat, le système de projection comprenant un miroir multicouche selon l'une quelconque des revendications précédentes.

7. Un système d'illumination configuré pour conditionner un faisceau de rayonnement, le système d'illumination comprenant un miroir multicouche selon l'une quelconque des revendications 1 à 5.

8. Un appareil de projection lithographique arrangé pour projeter un motif depuis un dispositif servant à conformer selon un motif sur un substrat, l'appareil lithographique comprenant un miroir multicouche selon l'une quelconque des revendications 1 à 5.

9. L'appareil lithographique selon la revendication 8, comprenant en outre :

   un système d'illumination configuré pour conditionner un faisceau de rayonnement ;
   une structure formant support construite pour porter un dispositif servant à conformer selon un motif, le dispositif servant à conformer selon un motif étant capable de conférer au faisceau de rayonnement un motif dans sa coupe transversale afin de former un faisceau de rayonnement à motif ;
   une table porte-substrat construite pour porter un substrat ; et
   un système de projection configuré pour projeter le faisceau de rayonnement à motif sur une portion cible du substrat.

10. Un appareil lithographique comprenant :

    un système d'illumination configuré pour conditionner un faisceau de rayonnement ;
    une structure formant support construite pour porter un dispositif servant à conformer selon un motif, le dispositif servant à conformer selon un motif étant capable de conférer au faisceau de rayonnement un motif dans sa coupe transversale afin de former un faisceau de rayonnement à motif ;
    une table porte-substrat construite pour porter un substrat ; et
    un système de projection configuré pour projeter le faisceau de rayonnement à motif sur une portion cible du substrat,
    dans lequel le système de projection est un système selon la revendication 6 et/ou le système d'illumination est un système selon la revendication 7.

Figure 1

Fig 2

11

Figure 3

Figure 4a

Figure 4b

U/B4C d=3.39nm, k=0.71, N=150

Figure 4c

EP 2 283 396 B1

EP 2 283 396 B1

Figure 5

Figure 6

EP 2 283 396 B1

Figure 7

EP 2 283 396 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61129087 B